# EUROPEAN PATENT APPLICATION

(11) **EP 2 000 958 A2**
(43) Date of publication of application: **10.12.2008**
(21) Application number: 07739626.5
(22) Date of filing: 26.03.2007
(51) Int. Cl.: G06K 19/077, G06K 19/07

(54) **IC MODULE, IC INLET AND IC MOUNTED BODY**

(30) Priority: 30.03.2006 JP 2006093349; 27.04.2006 JP 2006123420
(71) Applicant: Oji Paper Company Limited, Tokyo 104-0061 (JP); Soshin Electric Co. Ltd., Saku-shi, Nagano 385-0021 (JP)
(72) Inventor: KOJO, Kiyoshi, Tokyo 104-0061 (JP); TAJIMA, Yo, Tokyo 104-0061 (JP); HAYASHI, Toshimichi, Saku-shi Nagano 385-0021 (JP)
(74) Representative: Ilgart, Jean-Christophe
(86) International application number: PCT/JP2007/056188
(87) International publication number: WO 2007/116677

(57) **Abstract**

An IC module including: an insulating substrate 11; antenna connection terminals 16a and 16b provided on one surface of the insulating substrate 11; and a laminated body 15 in which an IC chip 14 and a mica capacitor 13 are laminated, wherein the laminated body 15 and the antenna connection terminals 16a and 16b are mounted on the same surface side of the insulating substrate 11, and the IC chip 14 and the mica capacitor 13 are electrically connected with the antenna connection terminals via a wire, the IC module capable of producing an IC mounted body that has highly accurate resonance frequency and is highly reliable in non-contact communications, and also capable of producing an IC mounted body having a small area since the mounting thereof on a small area is possible, and which can be produced by a general purpose apparatus for producing IC modules, as well as an IC inlet and an IC mounted body using the IC module are provided.

## Description

### TECHNICAL FIELD

The present invention relates to an IC module, an IC inlet, and an IC mounted body. More specifically, the present invention relates to an IC module, an IC inlet, and an IC mounted body which are capable of non-contact communication.

IC mounted bodies are those having an integrated circuit (IC) chip such as a memory microprocessor internally included in a card or the like and having an information storage/processing function, and they are also called data carriers.

Although they are commonly known as IC cards, they are not limited to those in the form of cards and also include various forms such as a sheet tag that can be pasted on an object, a tag sealed in a container, and a carrier shaped like a wristwatch.

Based on the communication system between the IC chip and the external devices, the IC mounted bodies are classified into three types; i.e., a contact type, a non-contact type, and a combined contact and non-contact type.

An IC mounted body of a contact type is one that has an external connection terminal exposed in the surface of the IC mounted body and carries out communication by bringing the external connection terminal into contact with an external device.

In addition, an IC mounted body of a non-contact type is one, which has a coil-shaped internal antenna embedded inside the IC mounted body and carries out communication with an external device due to the internal antenna without any contact therewith.

Moreover, an IC mounted body of a combined contact and non-contact type is one which has both the external connection terminal in the surface of the IC mounted body and the internal antenna, and in which the same single IC chip can communicate with an external device through either contact communication or non-contact communication. The combined contact and non-contact type is also known as a combined type or a dual interface type.

Among them, the present invention relates to an IC mounted body of a non-contact type and a combined contact and non-contact type (hereinafter, they are collectively referred to as a Radio Frequency Identification (RFID) type), and an IC module and an IC inlet that are used therein.

Priority is claimed on Japanese Patent Application No. 2006-093349, filed March 30, 2006, and Japanese Patent Application No. 2006-123420, filed April 27, 2006, the contents of which are incorporated herein by reference.

### BACKGROUND ART

The IC mounted body of an RFID type usually has a capacitor in addition to an antenna and the communication is achieved by the resonance frequency of a resonant circuit, which is constituted from the above components and an IC chip, matching with the wavelength of an electromagnetic wave radiated from an external device to resonate.

An IC card, in which an IC chip and a mica capacitor are mounted in parallel on one surface of an insulating substrate, is known as the IC mounted body of a RFID type having a capacitor as described above (Patent Document 1).

In addition, an IC card, in which a mica capacitor is configured by sandwiching part of a mica film with a pair of electrodes and an IC chip is mounted at a portion where this electrode of the mica film is not provided so as to be in parallel to the electrode, is known (Patent Document 2).
[Patent Document 1] Japanese Patent Publication No. 3687459
[Patent Document 2] Japanese Unexamined Patent Application, First Publication No.2001-43336

### DISCLOSURE OF INVENTION

### PROBLEMS TO BE SOLVED BY THE INVENTION

However, the accuracy of resonance frequency was not necessarily satisfactory with the conventional techniques described in Patent Documents 1 and 2 even though they employ capacitors with stable capacity such as a mica capacitor. For this reason, there were cases where reliability of the non-contact communication was unsatisfactory.

In addition, it is difficult to configure an IC module having an IC chip and a capacitor in a small area with either of the conventional techniques described in Patent Documents 1 and 2. Hence, it has been difficult to produce a coin-like IC mounted body having a small area, for example. In addition, since it is impossible to mount both an IC chip and a capacitor on the external connection terminals complying with the standards (i.e., ISO7816 and JISX6303), a general purpose apparatus for producing IC modules cannot be used resulting in the problem of high production cost.

The present invention is made in view of the above circumstances and the object thereof is to provide an IC module which is capable of producing an IC mounted body that has highly accurate resonance frequency and is highly reliable in non-contact communications, and also capable of producing an IC mounted body having a small area since the mounting thereof on a small area is possible, and which can be produced by a general purpose apparatus for producing IC modules.

In addition, by using this IC module, another object of the present invention is to provide an IC inlet and an IC mounted body that have highly accurate resonance frequency, and are highly reliable in non-contact communications, and which can be made to have a small area.

### MEANS FOR SOLVING THE PROBLEMS

As a result of studying the above problems, the present invention adopted the following aspects.
(1) An IC module characterized by having an insulating substrate, at least one pair of antenna connection terminals provided on one surface of the insulating substrate, and a laminated body in which an IC chip and a plate capacitor are laminated; and in which the laminated body and the at least one pair of antenna connection terminals are mounted on the same surface of the insulating substrate, and the IC chip and the plate capacitor are electrically connected with the at least one pair of antenna connection terminals.
(2) The IC module according to aspect (1) in which the plate capacitor is a mica capacitor.
(3) The IC module according to aspect (1) or (2) in which the IC chip and the plate capacitor are electrically connected with the at least one pair of antenna connection terminals by a wire.
(4) The IC module according to any one of aspects (1) to (3) further including an external connection terminal provided on the other surface of the insulating substrate which can become conductive upon contact with an external device and which is electrically connected with the IC chip.
(5) An IC inlet characterized in that an antenna is connected to the IC module of any one of aspects (1) to (4).
(6) An IC mounted body characterized in that a main body thereof internally includes the IC module of any one of aspects (1) to (4) and an antenna connected to the IC module.
(7) The IC mounted body characterized in that a main body thereof internally includes the IC module of aspect (4) and the antenna connected to the IC module in a state where the external connection terminal is exposed to a surface thereof.
(8) An IC module characterized by including a plate capacitor having at least one capacitor unit formed of a dielectric material, in which a first electrode is laminated on one surface and a second electrode is laminated on the other surface; a first electrode terminal and a second electrode terminal that are externally fitted respectively in opposing a first side surface and a second side surface of the plate capacitor; and an IC chip laminated on the plate capacitor; in which the first electrode of the at least one capacitor unit is electrically connected to the first electrode terminal in the first side surface, and in which the second electrode of the at least one capacitor unit is electrically connected to the second electrode terminal in the second side surface, and the IC chip is electrically connected with the first and second electrode terminals.
(9) The IC module according to aspect (8) in which the dielectric material is mica.
(10) The IC module according to aspect (8) or (9) in which the IC chip and the first and second electrode terminals are electrically connected via an anisotropically conductive resin film.
(11) An IC inlet characterized in that an antenna is connected to the first electrode terminal and the second electrode terminal of the IC module of any one of aspects (8) to (10).
(12) An IC mounted body characterized in that a main body thereof internally includes the IC module of any one of aspects (8) to (10) and an antenna connected to the first electrode terminal and the second electrode terminal of the IC module.

### EFFECTS OF THE INVENTION

By using the IC module of the present invention, it is possible to produce an IC mounted body that has a highly accurate resonance frequency and is highly reliable in non-contact communications. In addition, the IC module of the present invention can be mounted in small areas. For this reason, the IC module of the present is also capable of producing an IC mounted body having a small area and, at the same time, the IC module can be produced by a general purpose apparatus for producing IC modules.

Since the IC inlet and the IC mounted body of the present invention are using the IC module of the present invention, they have a highly accurate resonance frequency and are highly reliable in non-contact communications, and at the same time, they can also be produced to have a small area.

### BRIEF DESCRIPTION OF THE DRAWINGS

FIG. 1 is a cross sectional view showing an IC module of a first embodiment according to the present invention.
FIG. 2 is a front surface view showing the IC module of the first embodiment according to the present invention.
FIG. 3 is a back surface view showing the IC module of the first embodiment according to the present invention.
FIG. 4 is a cross sectional view showing a configuration example of a mica capacitor used in the present invention.
FIG. 5 is a cross sectional view showing another configuration example of a mica capacitor used in the present invention.
FIG. 6 is an explanatory diagram of a first embodiment of an IC mounted body according to the present invention.
FIG. 7 is a perspective view showing a second embodiment of an IC inlet of the present invention.
FIG. 8 is a cross sectional view showing the second embodiment of the IC inlet of the present invention.
FIG. 9 is a diagram showing an electrode pattern in the IC inlet of the present invention.
FIG. 10 is a diagram showing the electrode pattern in the IC inlet of the present invention.
FIG. 11 is a diagram showing an external electrode pattern in the IC inlet of the present invention.
FIG. 12 is a cross sectional view showing a third embodiment of the IC inlet of the present invention.

### DESCRIPTION OF THE REFERENCE SYMBOLS

- 10:: IC module;
- 11:: Insulating substrate;
- 12:: External connection terminal;
- 13:: Mica capacitor;
- 14:: IC chip;
- 15:: Laminated body;
- 16a and 16b:: Antenna connection terminal;
- 21a, 21b, 22a, 22b, and 26:: Wire;
- 30:: Sealer;
- 1 and 2:: IC inlet;
- 110 and 111:: Plate capacitor;
- 120 and 130:: Capacitor unit;
- 160:: First electrode terminal;
- 170:: Second electrode terminal;
- 180:: IC chip;
- 190:: Sealer;
- 100 and 101:: IC module;
- 200:: Antenna.

### BEST MODE FOR CARRYING OUT THE INVENTION

### (IC module)

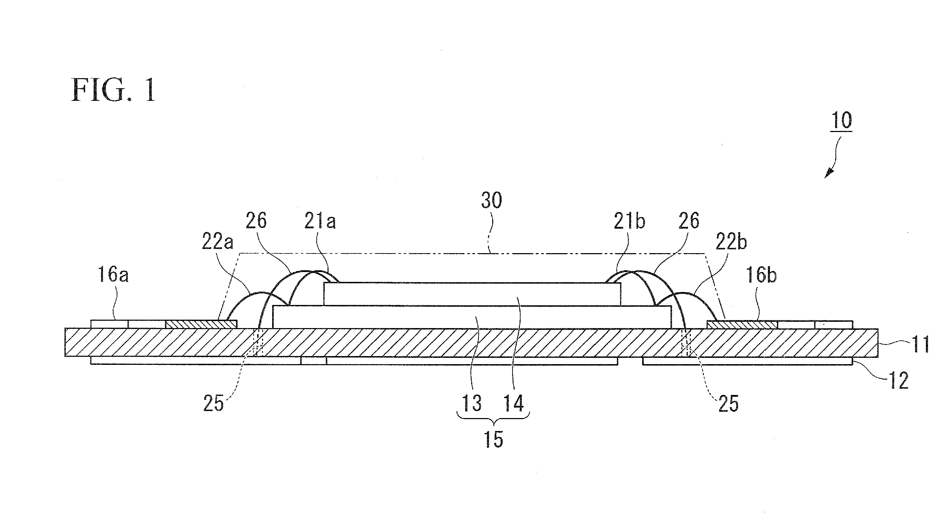

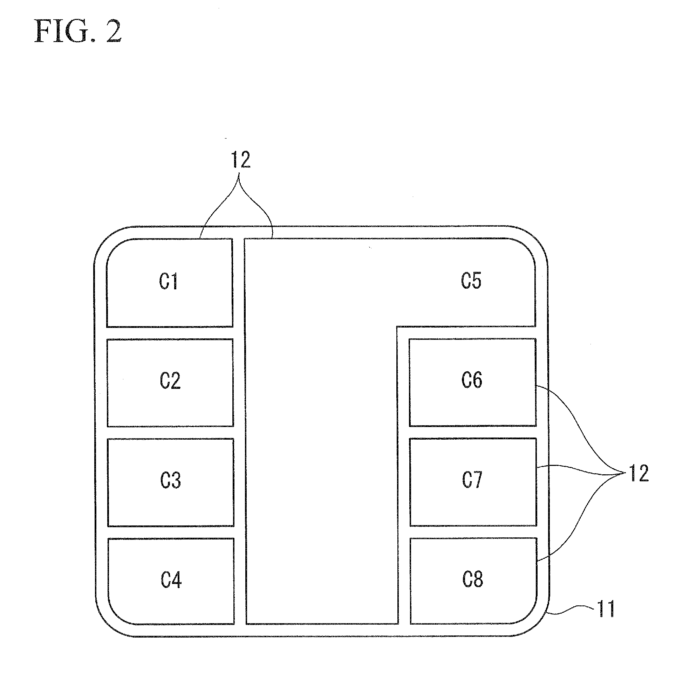

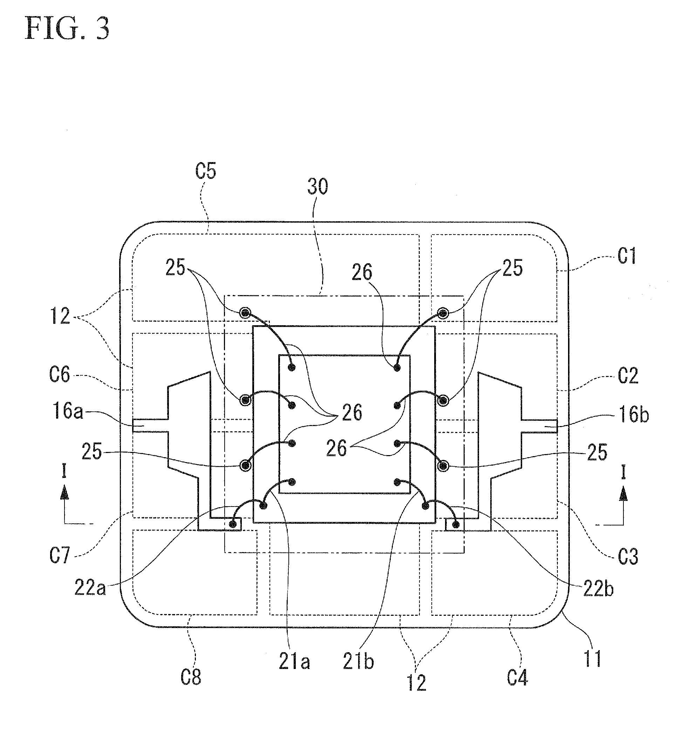

FIGS. 1 to 3 show an IC module of a combined contact and non-contact type being the IC module according to the first embodiment of the present invention. FIG. 1 is a cross sectional view shown by placing the front surface of the module to face downward, FIG. 2 is a front surface view, and FIG. 3 is a back surface view. Note that FIG. 1 is a cross sectional view taken along the line I-I in FIG. 3.

An IC module 10 of the present embodiment has an external connection terminal 12 complying with the standards (i.e., ISO7816 and JISX6303) on the front surface of an insulating substrate 11. In addition, a mica capacitor 13 and an IC chip 14 are sequentially laminated on the back surface of the insulating substrate 11. The mica capacitor 13 and the IC chip 14 constitute a laminated body 15. A pair of antenna connection terminals 16a and 16b is formed on the back surface of the insulating substrate 11 by interposing the laminated body 15 therebetween.

The IC chip 14 is electrically connected with the mica capacitor 13 by wires 21 a and 21b. In addition, the mica capacitor 13 is electrically connected with the antenna connection terminals 16a and 16b by wires 22a and 22b. In other words, the IC chip 14 is electrically connected to the antenna connection terminals 16a and 16b via the mica capacitor 13.

In addition, a plurality of conducting portions 25 are provided in the insulating substrate 11 and the IC chip 14 is electrically connected with the external connection terminal 12 at a plurality of connecting points via wires 26 passing through these conducting portions 25.

Moreover, a sealer 30 is provided, and the laminated body 15 and each of the wires are protected by being sealed by this sealer 30. Note that the sealer 30 is omitted in FIGS. 1 and 3 for convenience of illustration and the range where the sealer 30 is provided is shown by the broken line.

As a material for the insulating substrate 11, insulating materials such as a paper, a nonwoven fabric, a woven fabric, a film, a polyimide film substrate, a glass epoxy substrate, and a paper phenol substrate can be used. Examples of the film include general purpose films such as polyethylene terephthalate (PET), polyethylene naphthalate (PEN), polyphenylene sulfide (PPS), polybutylene terephthalate (PBT), polycarbonate (PC), acrylonitrile-butadiene-styrene (ABS) copolymer, polyvinyl chloride (PVC), a modified polyester resin (PET-G) in which at least 3 components (i.e., ethylene glycol, terephthalic acid, and 1,4-cyclohexane dimethanol) are polymerized, polypropylene (PP), polyethylene (PE), and polyimide.

Among them, a glass epoxy substrate and a polyimide film substrate are preferable from the viewpoint of heat resistance and cost.

The external connection terminal 12 is a terminal for the contact communication with external devices and is formed on the front surface of the insulating substrate 11 (underneath the substrate in FIG. 1). As shown in FIG. 2, the external connection terminal 12 has an external shape of round-cornered rectangles and the inside thereof is partitioned into C1 to C8 areas that are insulated from each other.

The external connection terminal 12 is formed by, for example, subjecting a copper foil adhered on the insulating substrate 11 to an etching treatment to form a predetermined pattern and applying nickel plating and gold plating thereon.

In the present embodiment, the IC chip 14 is electrically connected with 6 areas; i.e., C1 to C3 and C5 to C7 areas, via the conducting portions 25 and the wires 26.

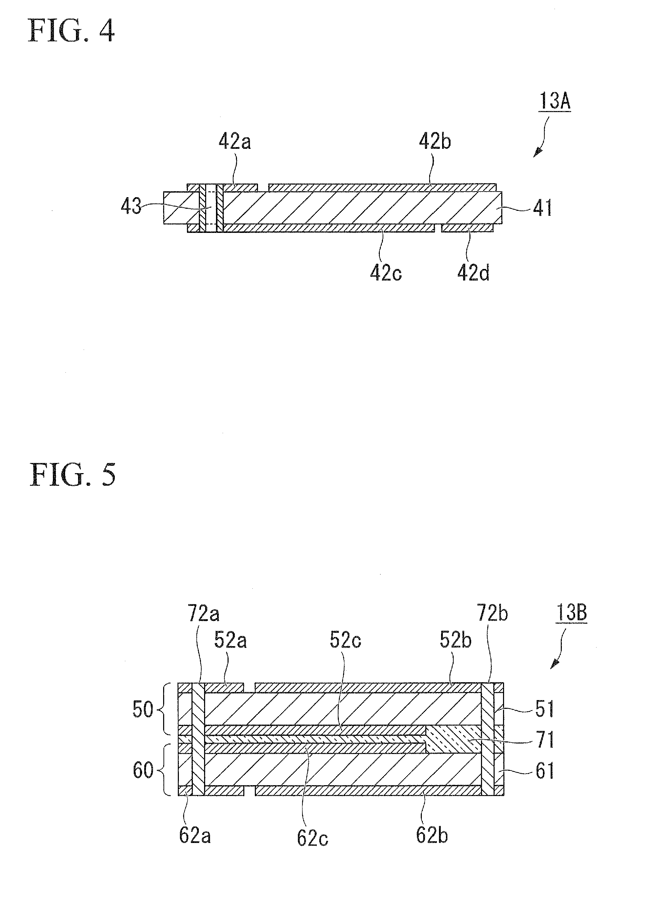

As the mica capacitor 13, a mica capacitor 13A shown in FIG. 4 or a mica capacitor 13B shown in FIG. 5, for example, can be used.

The mica capacitor 13A shown in FIG. 4 is a single layer capacitor and has a mica film 41 and electrodes 42a to 42d formed on both surfaces thereof. The electrodes 42a and 42c are connected by a through hole 43.

When the mica capacitor 13A is used, the wires 21 a and 22a shown in FIGS. 1 and 3 are connected to the electrode 42a whereas the wires 21 band 22b are connected to the electrode 42b so that a capacitor constituted between the electrodes 42b and 42c is connected to the IC chip 14 and the antenna connection terminals 16a and 16b in parallel. Note that the electrode 42d is a dummy electrode that does not have an electrical function and is arranged so that the under surface thereof aligns with that of the electrode 42c in order to adj ust the overall module thickness.

Although the thickness of the mica film 41 is not particularly limited, one having a thickness of 10 to 30 µm can suitably be used.

The electrodes 42a to 42d can be formed by various methods such as a deposition method, a plating method, and a printing method. When formed by a printing method, they are formed using a conductive ink obtained by kneading fine metal powder with a liquid resin or a glass frit. In this case, fine powders of metals such as silver, gold, copper, nickel, and aluminum can be used as the fine metal powder. Although the thickness of the electrodes 42a to 42d is not particularly limited, one having a thickness of 10 µm or less can suitably be used.

The through hole 43 is formed by providing a through hole penetrating the entire capacitor 13A and then coating the inner surface of the through hole with a conductive material. As the conductive material to be coated, the same conductive ink used when forming the electrodes 42a to 42d by the printing method can be used.

The mica capacitor 13B shown in FIG. 5 is a double layer capacitor in which a capacitor 50 and a capacitor 60 are laminated.

The capacitor 50 has a mica film 51 and electrodes 52a to 52c formed on the both surfaces thereof. The capacitor 60 has a mica film 61 and electrodes 62a to 62c formed on the both surfaces thereof. An adhesive glass layer 71 is formed between the capacitor 50 and the capacitor 60, thereby adhering the electrode 52c and the electrode 62c. In addition, vias 72a and 72b are provided by penetrating the capacitor 50 and the capacitor 60. The electrodes 52a, 52c, 62c, and 62a are connected with each other by the via 72a and the electrodes 52b and 62b are connected with each other by the via 72b.

When the mica capacitor 13B is used, the wires 21a and 22a shown in FIGS. 1 and 3 are connected to the electrode 52a whereas the wires 21b and 22b are connected to the electrode 52b so that the capacitor 50 constituted between the electrodes 52b and 52c and the capacitor 60 constituted between the electrodes 62b and 62c are connected to the IC chip 14 and the antenna connection terminals 16a and 16b in parallel.

As the mica films 51 and 61, the same film as the mica film 41 can be used.

As the electrodes 52a to 52c and 62a to 62c, the same electrodes as the electrodes 42a to 42d can be used. Examples of the materials for the adhesive glass layer 71 include a low melting point glass having a borosilicate glass as its major component. The vias 72a and 72b are those formed by providing a through hole penetrating the entire capacitors 50 and 60 and then filling in the through hole with a conductive material. As the conductive material to be filled in, the same conductive ink used when forming the electrodes 42a to 42d by the printing method can be used.

Examples of the IC chip 14 include the bare chips that are capable of non-contact communication around the frequency bands of 135 kHz, 4.9 MHz, 6.5 MHz, 13.56 MHz, 2.54 GHz, and the like.

The antenna connection terminals 16a and 16b are produced on the insulating substrate 11 using a metal foil by processes such as an etching process, a printing process, a wiring process, a deposition process, and a plating process. As the metal foil constituting the antenna connection terminals 16a and 16b, gold, copper, aluminum, silver, nickel, or the like can be used.

Although gold wires are preferable as the wires 21a, 21b, 22a, 22b, and 26, the wires of silver, platinum, aluminum, copper, or the like can also be used.

As the sealer 30, an epoxy resin, a silicon resin, a polyester resin, or the like can be used.

Since the mica capacitor 13 and the IC chip 14 are laminated and mounted on the insulating substrate 11 on the same side as the antenna connection terminals 16a and 16b in the IC module 10 of the present embodiment, it is possible to shorten the wirings (i.e., the wires 21a, 21b, 22a, and 22b) that connect between the mica capacitor 13, the IC chip 14, and the antenna connection terminals 16a and 16b.

The present inventors discovered that deviations in the resonance frequency occur due to the inductance and resistance of the connecting wires themselves in the conventional IC mounted bodies. Since the IC module 10 of the present embodiment is capable of reducing the effects on the resonance frequency by shortening the connecting wires, it is possible to produce an IC mounted body that has a highly accurate resonance frequency and is highly reliable in non-contact communications by including the IC module internally.

In addition, since the mica capacitor 13 and the IC chip 14 are laminated and mounted on the insulating substrate 11 in the IC module 10 of the present embodiment, the IC module can be mounted in a small area. For this reason, it is possible to configure the IC module 10, which also has a capacitor, within an area range of the external connection terminals complying with the standards (i.e., ISO7816 and JISX6303). Accordingly, the IC module 10 of the present embodiment can be produced by a general purpose production apparatus that has been used for producing IC modules without a capacitor, and thus low cost production can be achieved.

In addition, since the mica capacitor 13 that has a stable capacity is used as a plate capacitor in the present embodiment, it is possible to achieve resonance frequency with even higher accuracy. Moreover, since the mica capacitor is highly heat resistant, processing steps such as a soldering step and a press working step can be adopted without any problems and the IC module and the IC mounted body using the IC module can be readily produced.

In addition, since the mica capacitor 13, the IC chip 14, and the antenna connection terminals 16a and 16b are connected by wires in the present embodiment, the connections can be made regardless of the sizes of the mica capacitor 13 and the IC chip 14, or the like.

Moreover, since the IC module 10 has the external connection terminal 12, it is possible to produce an IC mounted body capable of contacting communications by internally including the module while exposing this terminal on the surface. That is, it is possible to obtain an IC mounted body of a combined contact and non-contact type.

Note that the IC module of the present invention is not limited to the above embodiment. Although it is configured that the mica capacitor 13 and the IC chip 14 are laminated on the back surface of the insulating substrate 11 in this order in the above embodiment, the order of the mica capacitor 13 and the IC chip 14 may be interchanged. In other words, it may be configured so that the IC chip 14 and the mica capacitor 13 are laminated on the back surface of the insulating substrate 11 in this order.

In addition, although FIGS. 4 and 5 are shown as the specific configuration of the mica capacitor 13 in the present embodiment, the specific configuration of the mica capacitor 13 is not particularly limited and, for example, it is also possible to configure by laminating 3 or more capacitors.

Moreover, the plate capacitor used in the present invention is not limited to a mica capacitor and a ceramic capacitor, a film capacitor, or the like may be used.

In addition, although the mica capacitor 13, the IC chip 14, and the antenna connection terminals 16a and 16b are connected by wires in the present embodiment, these electrical connections are not limited to those achieved by the wires and may be achieved, for example, by adhesion using an anisotropically conductive resin film (ACF). Note that in this case, connecting surfaces of each member need to face each other.

For example, when the mica capacitor 13B shown in FIG. 5 in which the same electrode can be connected from both sides is used, the IC chip 14 can be ACF-connected with the electrode 52a and the electrode 52b by being superimposed on the mica capacitor 13B face down. On the other hand, by making the size of the under surface side of the mica capacitor 13B so as to be superimposed on the antenna connection terminals 16a and 16b, the ACF connection between the electrodes 62a and 62b and the antenna connection terminals 16a and 16b can be achieved.

In addition, although the IC module 10 of the present embodiment has the external connection terminal 12, external connection terminals are not essential. When the IC module does not have an external connection terminal, it is possible to produce an IC mounted body that is only capable of non-contact communications by including the IC module internally. In other words, a non-contact IC mounted body can be obtained.

In addition, although the IC module 10 of the present embodiment is configured so as to have a pair of antenna connection terminals 16a and 16b, it may be configured so as to have two or more pairs of antenna connection terminals.

### (IC inlet)

The IC inlet of the present invention is one in which an antenna is connected to the IC module of the present invention. The IC inlet using the IC module 10 according to the embodiment shown in FIGS. 1 to 3 will be described as a first embodiment of the IC inlet of the present invention.

When the IC module 10 is used, both ends of the antenna are connected to the antenna connection terminals 16a and 16b. The mica capacitor 13 and the antenna are connected in parallel to the IC chip 14 to form a resonant circuit. For this reason, it is possible to obtain an IC mounted body capable of non-contact communications between the IC chip 14 and external devices when the IC inlet of the present embodiment is internally included in the body.

In addition, since the IC module 10 has the external connection terminal 12, it is possible to obtain an IC mounted body of a combined contact and non-contact type which is also capable of communications by the contact system between the IC chip and external devices due to the internal inclusion of the module in the body while exposing this terminal on the surface.

The antenna is preferably formed on an insulating support for the sake of handling convenience. In this case, by integrating the insulating support on which the antenna is formed and the IC module of the present invention, it is possible to form an IC inlet in which the IC module and the antenna are integrated.

The insulating support on which the antenna is formed can be obtained, for example, by preparing a circuit substrate due to the adhesion of an insulating support and a metal foil followed by the patterning of the metal foil of this circuit substrate.

The patterning of the metal foil can be carried out as follows, for example. First, a photosensitive resin layer is provided on the metal foil of the circuit substrate and a pattern is drawn directly on the metal foil of the circuit substrate by the method in which the photosensitive resin layer is patterned using a mask formed by a negative or a positive photographic film, or a chromium film; or by various methods such as a printing method and a lettering method. By using the formed pattern as a mask, the metal foil pattern can be formed by eluting unnecessary metal parts due to a so-called etching process using a ferric chloride solution, a caustic soda solution, or the like.

Materials for the insulating support can be selected from the same materials as those listed for the insulating substrate of the IC module.

Examples of the materials of the metal foil for forming the antenna include copper, silver, aluminum, gold, or an alloy thereof, or a conductive ink containing a fine metal powder of these metals.

Note that if an antenna wire in which an antenna is covered by an insulating material is used, it will easily multiply wind and the degree of freedom concerning the configuration of the antenna in the IC inlet will be high.

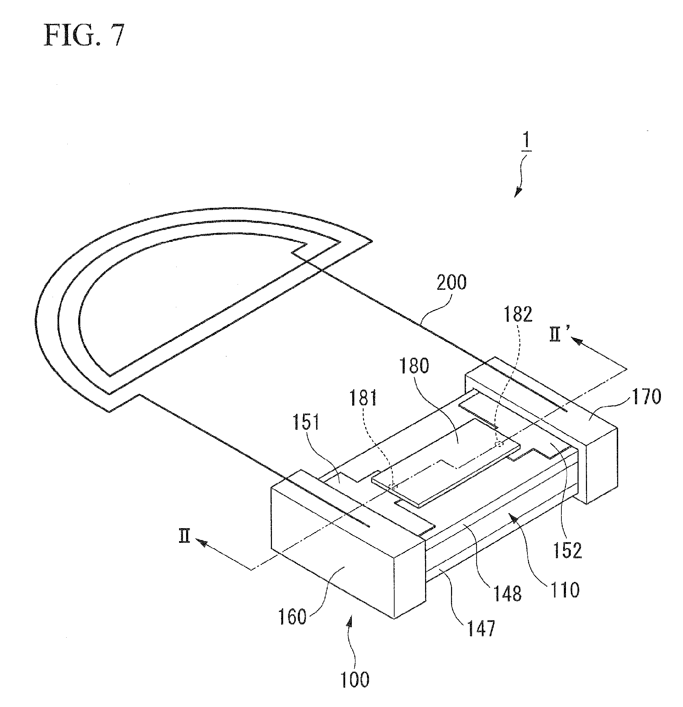

FIG. 7 is a perspective view of an IC inlet 1 according to a second embodiment of the present invention. The IC inlet 1 of the present embodiment is configured from an IC module 100 according to the second embodiment of the present invention and an antenna 200 connected to this IC module 100.

The IC module 100 has a plate capacitor 110, a first electrode terminal 160 and a second electrode terminal 170 each externally fitting in the opposing two side surfaces (a first side surface and a second side surface) of the plate capacitor 110, and an IC chip 180 laminated on the plate capacitor 110.

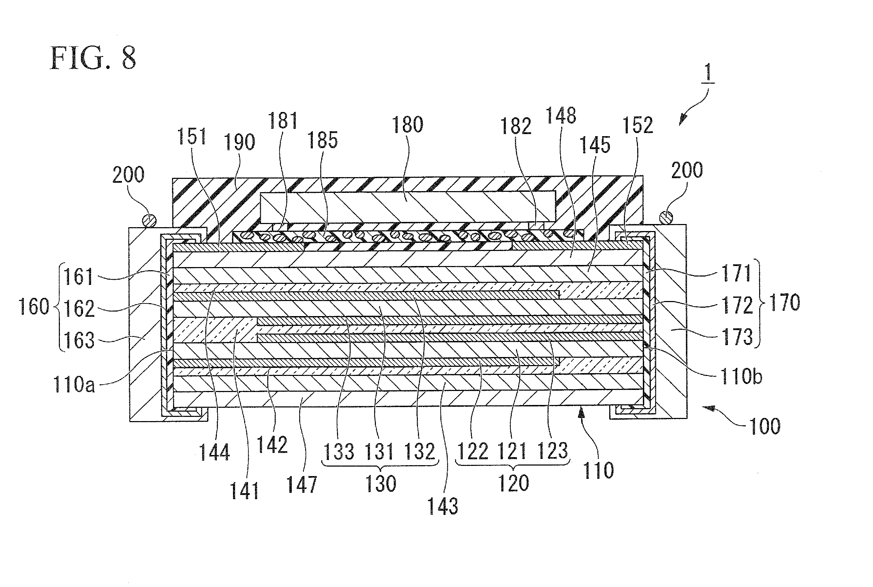

FIG. 8 is a cross sectional view taken along the line II-II' in FIG. 7. Note that the thickness of each layer in FIG. 8 is different from that of the actual layer for the convenience of illustration.

As shown in FIG. 8, the plate capacitor 110 has a capacitor unit 120 and a capacitor unit 130. The capacitor unit 120 has a mica film 121, and electrodes 122 and 123 formed on the under surface and top surface of the film, respectively. The capacitor unit 130 has a mica film 131, and electrodes 132 and 133 formed respectively on the under surface and top surface of the film.

An adhesive glass layer 141 is provided between the capacitor unit 120 and the capacitor unit 130 to bond the electrode 123 and the electrode 133.

In addition, in the plate capacitor 110, a mica film 143 is laminated on the under surface side of the capacitor unit 120 via an adhesive glass layer 142. Moreover, a mica film 145 is laminated on the top surface side of the capacitor unit 130 via an adhesive glass layer 144. An armor 147 and an armor 148 are laminated respectively on the lower side of the mica film 143 and on the upper side of the mica film 145. An external electrode 151 and an external electrode 152 are provided on the top surface of the armor 148 and the plate capacitor 110 is configured from a laminated body of these components.

A first electrode terminal 160 that externally fits one side surface 110a (first side surface) of the plate capacitor 110 therein is configured from three layers; i.e., a conductive resin layer 161, a nickel layer 162, and a solder plating layer 163 in this order from the inside. Likewise, a second electrode terminal 170 that externally fits the other side surface 110b (second side surface) of the plate capacitor 110 therein is configured from three layers; i.e., a conductive resin layer 171, a nickel layer 172, and a solder plating layer 173 in this order from the inside.

An IC chip 180 has bumps 181 and 182 on its under surface. In addition, an anisotropically conductive resin film 185 is provided between the IC chip 180 and the plate capacitor 110, and the bump 181 and the bump 182 are respectively connected to the external electrode 151 and the external electrode 152 via this anisotropically conductive resin film 185.

Moreover, in the present embodiment, a sealer 190 is provided from part of the first electrode terminal 160 to part of the second electrode terminal 170 so as to cover the IC chip 180. Note that the sealer 190 is omitted in FIG. 7 for convenience of illustration.

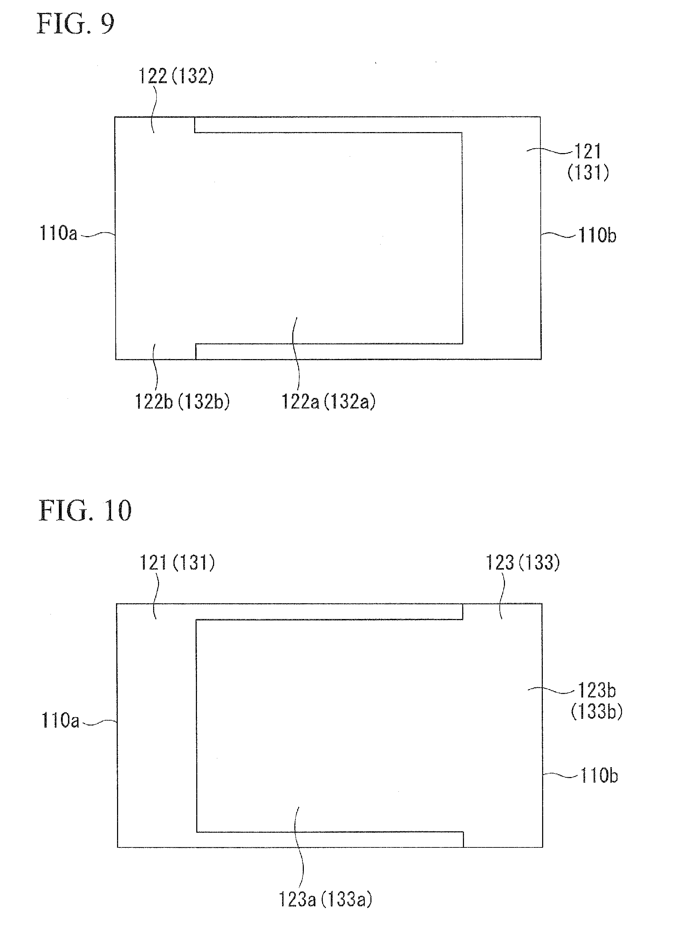

FIG. 9 is a diagram viewing the electrode 122 (electrode 132) from the under surface side. In addition, FIG. 10 is a diagram viewing the electrode 123 (electrode 133) from the top surface side. As shown in FIGS. 9 and 10, parts of the electrodes 122, 132, 123, and 133 in almost central portions of the plate capacitor 110 respectively make up electrode main bodies 122a, 132a, 123a, and 133a that are formed inside in the width direction.

The mica film 121 (mica film 131) is sandwiched by the electrode 122 (electrode 132) and the electrode 123 (electrode 133) at the electrode main body 122a (electrode main body 132a) and the electrode main body 123a (electrode main body 133a), thereby constituting the capacitor.

In addition, part of the electrode 122 (electrode 132) in the side surface 110a side of the plate capacitor 110 makes up a connecting portion 122b (connecting portion 132b) formed on the whole surface in the width direction, and this connecting portion 122b (connecting portion 132b) is brought into contact with the conductive resin layer 161 of the first electrode terminal 160 to be electrically connected therewith.

Likewise, part of the electrode 123 (electrode 133) in the side surface 110b side of the plate capacitor 110 makes up a connecting portion 123b (connecting portion 133b) formed on the whole surface in the width direction, and this connecting portion 123b (connecting portion 133b) is brought into contact with the conductive resin layer 171 of the second electrode terminal 170 to be electrically connected therewith.

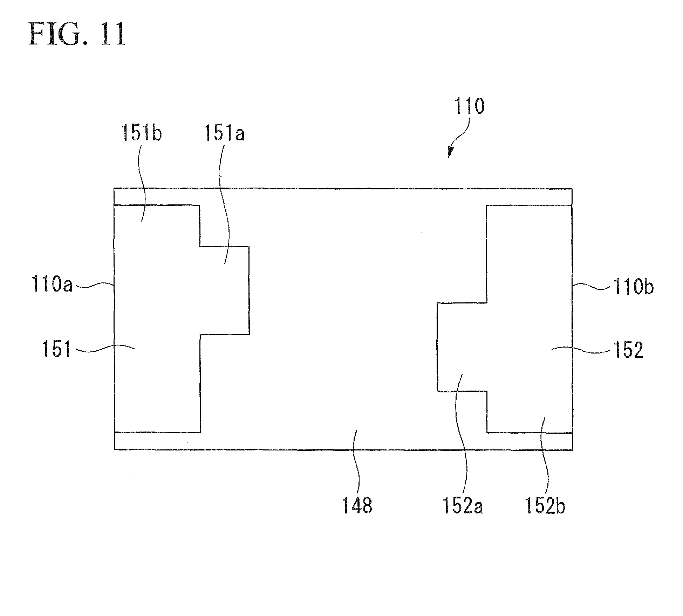

FIG. 11 shows a pattern of these external electrodes 151 and 152.

As shown in FIG. 11, the external electrodes 151 is constituted from a bump connecting portion 151a and a terminal connecting portion 151b, and it is configured so that the bump 181 connects to the bump connecting portion 151 a via the anisotropically conductive resin film 185 and so that the first electrode terminal 160 that externally fits the side surface 110a side therein connects to the terminal connecting portion 151b.

Likewise, the external electrodes 152 is constituted from a bump connecting portion 152a and a terminal connecting portion 152b, and it is configured so that the bump 182 connects to the bump connecting portion 152a via the anisotropically conductive resin film 185 and so that the second electrode terminal 170 that externally fits the side surface 10b side therein connects to the terminal connecting portion 152b.

In the top surface side of the plate capacitor 110, the antenna 200 is connected to the solder plating layer 163 of the first electrode terminal 160 and the solder plating layer 173 of the second electrode terminal 170 both at the portions that are not covered by the sealer 190.

As a result of these connection relationships, a resonant circuit in which the capacitor unit 120, the capacitor unit 130, and the antenna 200 are connected in parallel with respect to the IC chip 180 is formed.

Materials for the armors 147 and 148 in the present embodiment can be selected from the same materials as those listed for the above-mentioned insulating substrate 11.

Although the thickness of the armors 147 and 148 is not particularly limited, 10 to 300 µm is preferable and 100 to 200 µm is more preferable in order to retain the strength of the IC module 100.

As the mica films 121, 131, 143, and 145 in the present embodiment, a film equivalent to that used as the mica film 41 can be used.

In addition, as the electrodes 122, 123, 132, and 133, electrodes equivalent to those used for the electrodes 42a to 42d can be used.

As materials for the adhesive glass layers 141, 142, and 144, materials equivalent to those used for the adhesive glass layer 71 can be used.

The external electrodes 151 and 152 can be formed on the armor 148 using a metal foil by processes such as an etching process, a printing process, a wiring process, a deposition process, and a plating process. As the metal foil constituting the external electrodes 151 and 152, gold, copper, aluminum, silver, nickel, or the like can be used.

As the IC chip 180, one which is equivalent to that used as the IC chip 14 can be used.

As the sealer 190, one which is equivalent to that used as the sealer 30 can be used.

The antenna 200 is preferably formed on an insulating support for the sake of handling convenience in the IC inlet 1 of the present embodiment, and the antenna equivalent to that described in the IC module 10 can be used.

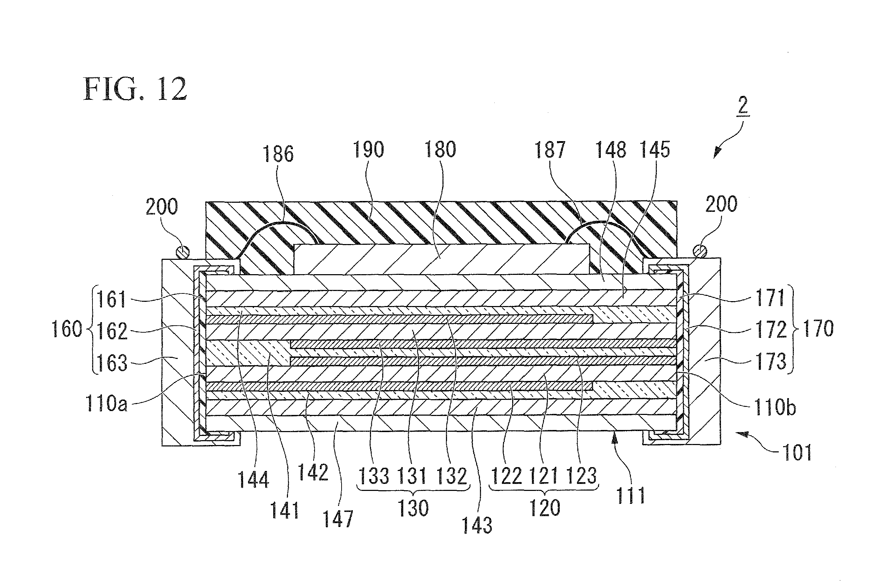

FIG. 12 is a cross sectional view of an IC inlet 2 according to a third embodiment of the present invention. Note that the constituting members equivalent to those in FIG. 8 are given the same reference symbols in FIG. 12 and detailed descriptions thereon are omitted.

The IC inlet 2 of the present embodiment is configured from an IC module 101 according to the third embodiment of the present invention and the antenna 200 connected to this IC module 101.

The IC module 101 has a plate capacitor 111, a first electrode terminal 160 and a second electrode terminal 170 each externally fitting in the opposing two side surfaces (a first side surface and a second side surface) of the plate capacitor 111, and an IC chip 180 laminated on the plate capacitor 110.

The plate capacitor 111 in the present embodiment is the same as the plate capacitor 110 in the second embodiment except that the external electrodes 151 and 152 are not provided.

In the IC module 101 of the present embodiment, the IC chip 180, the first electrode terminal 160, and the second electrode terminal 170 are connected by wires 186 and 187. Note that the IC chip 180 is in a face-up state, and thus opposite to that of the IC chip 180 in the second embodiment.

Although gold wires are preferable as the wires 186 and 187, the wires of silver, platinum, aluminum, copper, or the like can also be used.

In the present embodiment, the wires 186 and 187 are also contained in the sealer 190.

With the IC modules 100 and 101 in each of the above embodiments, it is not necessary to provide a wiring separately for connecting the antenna 200 since the antenna 200 can be connected when laminating the IC chip 180 on the top surface side of the plate capacitors 110 and 111.

The present inventors discovered that deviations in the resonance frequency occur due to the inductance and resistance of the connecting wires themselves in the conventional IC mounted bodies. Since the IC modules 100 and 101 in the above embodiments are capable of reducing the effects on the resonance frequency by omitting unnecessary wirings, it is possible to produce an IC mounted body that has highly accurate resonance frequency and is highly reliable in non-contact communications by including the IC modules internally.

In addition, since the IC modules 100 and 101 in the above embodiments have the IC chip 180 laminated on the top surface side of the plate capacitors 110 and 111, they can be mounted in small areas. For this reason, it is possible to produce an IC mounted body having a small area by including the IC modules internally.

In addition, since the mica capacitor employing a mica film that has a stable capacity is used as the plate capacitors 110 and 111 in the IC modules 100 and 101 of the above embodiments, it is possible to achieve resonance frequency with even higher accuracy. Moreover, since the mica capacitor is highly heat resistant, processing steps such as a soldering step and a press working step can be adopted without any problems and the IC module and the IC mounted body using the IC module can be readily produced.

Note that the IC module of the present invention is not limited to the above embodiments. Although the plate capacitors in the above embodiments are all configured to have 2 capacitor units, the specific configuration of the plate capacitors is not particularly limited and, for example, it is also possible to configure the plate capacitors by laminating 3 or more capacitor units.

In addition, the configuration of the first and the second electrode terminals is not limited to the 3 layer structure and it may be a 1 layer structure, a 2 layer structure, or a structure of 4 or more layers.

Moreover, the plate capacitor used in the present invention is not limited to a mica capacitor and a ceramic capacitor, a film capacitor, or the like may be used.

Additionally, although the IC inlets in each of the above embodiments are all configured to have one antenna 200, they may be configured to have a plurality of antennas connected in parallel.

Moreover, in the second embodiment, although the configuration in which the antenna 200 is wound at a location distant from the IC module 100 is shown in FIG. 7, it is also possible, for example, to configure the antenna to be wound so as to surround the IC module. In this case, it will be possible to produce an IC mounted body having even smaller areas by internally including this IC module.

As a main body of an IC mounted body, in which the IC inlet of the present invention is internally included, those having various shapes such as a card shape, a coin shape, a star shape, a key shape, a peanut shape, and a cylinder shape can be adopted. In addition, it is also possible to configure an IC tag that is capable of being pasted on an object to be adhered by providing an adhesive layer on either one side or both sides of the main body.

The IC module used in the IC inlet of the present invention is not limited to the IC modules 10, 100, and 101, and IC modules of various forms described above can be used. For example, when an IC module having no external connection terminal is used, an IC inlet capable of only non-contact communications between an IC chip and an external device is achieved. In this case, it is possible to obtain an IC mounted body of a non-contact type when this IC inlet is internally included in the main body. In addition, when an IC module having two or more pairs of antenna connection terminals is used, an IC inlet in which a plurality of antennas are connected can be achieved.

### (IC mounted body)

The IC mounted body of the present invention is one in which a main body thereof internally includes the IC module of the present invention and an antenna connected to the IC module.

Note that the antenna may be internally included in the main body after being integrated with the IC module in advance to constitute the IC inlet or the antenna may be formed in advance inside the main body followed by the fitting of the IC module thereto.

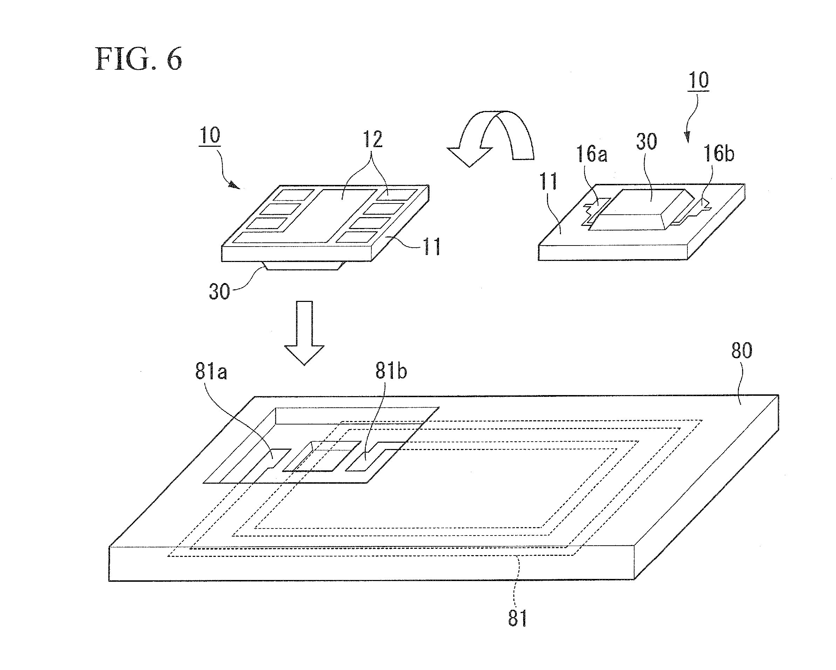

An IC mounted body in which an antenna is formed inside the main body in advance will be described using FIG. 6.

FIG. 6 is an explanatory diagram concerning an IC card using the IC module 10 according to the embodiment shown in FIGS. 1 to 3 as a first embodiment of an IC mounted body of the present invention. Note that the same constituting members as those in FIGS. 1 to 3 are given the same reference symbols in FIG. 6 and the detailed descriptions thereon are omitted.

The IC card of the present embodiment is one configured by fitting the IC module 10 to a card main body 80, in which an antenna 81 is formed inside in advance, as shown in FIG. 6. Due to the fitting process, the IC module 10 is internally included in the card main body 80 while the external connection terminal 12 is being exposed in the surface of the card main body 80. By bringing this exposed external connection terminal 12 into contact with an external device, contact communications between the IC chip 14 inside the IC module 10 and the external device will be possible.

In addition, by fitting the IC module 10 in the card main body 80, the antenna connection terminals 16a and 16b and terminals 81a and 81b of the antenna 81 can be brought into contact for connection.

Note that in order to form a more reliable connection between the antenna connection terminals 16a and 16b and the terminals 81a and 81b, it is preferable to interpose conductive paste, a conductive sheet, or the like between the two types of terminals.

Due to this configuration, a resonant circuit in which the mica capacitor 13 and the antenna are connected in parallel to the IC chip 14 of the IC module 10 is formed and the non-contact communications between the IC chip 14 and the external device will be possible. In other words, the IC card of the present embodiment is an IC card of a combined contact and non-contact type.

Note that the card main body 80 in which the antenna 81 is formed in advance can be obtained, for example, by forming an antenna in one of the paired main-body substrates and thereafter joining these substrates.

An antenna can be formed in one of the paired main-body substrates due to the same process as the one employed for preparing the insulating support, in which an antenna is formed, described in the above-mentioned IC inlet where a metal foil is adhered to the main-body substrate followed by the patterning of the metal foil.

Note that if an antenna wire in which an antenna is covered by an insulating material is used, it will easily multiply wind, and the degree of freedom concerning the configuration of the antenna in the card main body 80 will be high.

As the material for the card main body 80 (main body substrate), film or sheet-formed polyester, polycarbonate, ABS, PET-G, polyvinyl chloride, polyethylene, polypropylene, nylon, polyimide, polystyrene, polymer alloys, plastic films such as engineering plastics, single bodies or complexes such as papers, meshes, and nonwoven fabrics, substrates, in which an epoxy resin or the like is impregnated in glass fibers or papers, and the like can be used.

In addition, a printed layer, a magnetic layer, a protective layer, or the like may be provided on the surface of these substrates and the like. Moreover, functional surface coating such as thermal coating, thermal transfer coating, and ink jet coating may be applied.

The shape of the IC mounted body of the present invention is not limited to a card shape and those having various shapes such as a coin shape, a star shape, a key shape, a peanut shape, and a cylinder shape can be adopted. In addition, it is also possible to configure an IC tag that is capable of being pasted on an object to be adhered by providing an adhesive layer on either one side or both sides of the main body.

The IC module used in the IC mounted body of the present invention is not limited to the IC modules 10, 100, and 101, and IC modules of various forms described above can be used. For example, when an IC module having no external connection terminal is used, an IC mounted body of a non-contact type that is capable of only non-contact communications between an IC chip and an external device can be achieved. In addition, when an IC module having two or more pairs of antenna connection terminal is used, an IC mounted body having a plurality of antennas that are connected to this IC module can be achieved.

### INDUSTRIAL APPLICABILITY

By including the IC module of the present invention internally, it is possible to produce an IC mounted body that has a highly accurate resonance frequency and is highly reliable in non-contact communications. In addition, the IC module of the present invention can be mounted in small areas. For this reason, the IC module of the present is also capable of producing an IC mounted body having a small area and, at the same time, the IC module can be produced by a general purpose apparatus for producing IC modules.

Since the IC inlet and the IC mounted body of the present invention are using the IC module of the present invention, they have highly accurate resonance frequency and are highly reliable in non-contact communications, and at the same time, they can also be produced to have a small area.

## Claims

1. An IC module comprising:
an insulating substrate;
at least one pair of antenna connection terminals provided on one surface of the insulating substrate; and
a laminated body in which an IC chip and a plate capacitor are laminated,
wherein the laminated body and the at least one pair of antenna connection terminals are mounted on the same surface side of the insulating substrate, and
the IC chip and the plate capacitor are electrically connected with the at least one pair of antenna connection terminals.

2. The IC module according to Claim 1, wherein the plate capacitor is a mica capacitor.

3. The IC module according to Claim 1 or 2,
wherein the IC chip and the plate capacitor are electrically connected with the at least one pair of antenna connection terminals by a wire.

4. The IC module according to any one of Claims 1 to 3, further comprising an external connection terminal provided on the other surface of the insulating substrate which can become conductive upon contact with an external device and which is electrically connected with the IC chip.

5. An IC inlet comprising:
the IC module of any one of Claims 1 to 4; and
an antenna connected to the IC module.

6. An IC mounted body comprising:
a main body;
the IC module of any one of Claims 1 to 4; and
an antenna connected to the IC module,
wherein the IC module and the antenna are internally included in the main body.

7. An IC mounted body comprising:
a main body;
the IC module of Claim 4; and
an antenna connected to the IC module,
wherein the IC module and the antenna are internally included in the main body in a state where the external connection terminal is exposed in a surface thereof.

8. An IC module comprising:
a plate capacitor having at least one capacitor unit formed of a dielectric material, in which a first electrode is laminated on one surface and a second electrode is laminated on the other surface;
a first electrode terminal and a second electrode terminal that externally fit respectively in an opposing first side surface and second side surface of the plate capacitor;
an IC chip laminated on the plate capacitor,
wherein the first electrode of the at least one capacitor unit is electrically connected to the first electrode terminal in the first side surface,
the second electrode of the at least one capacitor unit is electrically connected to the second electrode terminal in the second side surface, and
the IC chip is electrically connected with the first electrode terminal and the second electrode terminal.

9. The IC module according to Claim 8, wherein the dielectric material is mica.

10. The IC module according to Claim 8 or 9,
wherein the IC chip and the first and second electrode terminals are electrically connected via an anisotropically conductive resin film.

11. An IC inlet comprising:
the IC module of any one of Claims 8 to 10; and
an antenna connected to the first electrode terminal and the second electrode terminal of the IC module.

12. An IC mounted body comprising:
a main body;
the IC module of any one of Claims 8 to 10; and
an antenna connected to the first electrode terminal and the second electrode terminal of the IC module,
wherein the IC module and the antenna are internally included in the main body.
